# EUROPEAN PATENT SPECIFICATION

(11) **EP 2 853 140 B1**
(45) Date of publication and mention of the grant of the patent: **29.07.2020**
(21) Application number: 12761806.4
(22) Date of filing: 21.05.2012
(51) Int. Cl.: H05K 1/02

(54) **INTERCONNECTION SUBSTRATE AND METHOD OF MANUFACTURING THE SAME**
VERBINDUNGSSUBSTRAT UND VERFAHREN ZUR HERSTELLUNG DAVON
SUBSTRAT D'INTERCONNEXION ET SON PROCÉDÉ DE FABRICATION

(43) Date of publication of application: 01.04.2015
(73) Proprietor: Linxens Holding, 78280 Guyancourt (FR)
(72) Inventor: LECHLEITER, François, F-78200 Favrieux (FR)
(74) Representative: Regi, François-Xavier
(86) International application number: PCT/IB2012/001596
(87) International publication number: WO 2013/175261

(56) References cited:
- WO-A1-03/026010
- GB-A- 1 581 595
- US-A- 5 112 230
- US-A1- 2003 037 961
- US-A1- 2008 142 071

## Description

### Field of the invention

The present invention relates to the field of substrates for interconnecting components. More particularly, the interconnection substrates of the invention are printed circuit substrates usually used for instance with surface mounting, chip on board technologies or chip on flex technologies.

### Background of the invention

In electronic circuits, an interconnection substrate, such as for instance a Printed Circuit Board (PCB), a Flexible Printed Circuit (FPC) or a Flexible Etched Circuit (FEC) is used to mechanically support and electrically interconnect electronic components. An example of process for making such a circuit is described in WO03026010A1 or in US 2008/142071A1.

Electrically conductive traces are designed on or within the interconnection substrates to electrically connect an output terminal of a component to an input terminal of another component. Usually, conductive pads are also designed on or within the interconnection substrate, at some trace ends to ease the electrical connection between a trace and a component terminal.

Traditionally, interconnection substrates are delivered with a specific pattern already defining how the components will be interconnected together. For complex interconnection substrate, a specific inspection called "electrical test" is performed by the PCB/FPC/FEC manufacturer, to check whether the electrical function is conformed to what is expected.

Electronic components are then mounted onto the surface of the interconnection substrate. Electronic components can be mounted as surface mounted devices, this is usually called surface mounting technology. Electronic components can also be bare dies (chips), that case is referred to as Chip On Board (COB) or Chip On Flex (COF) technologies. An electrical functional test is usually performed after components are mounted onto the interconnection substrate.

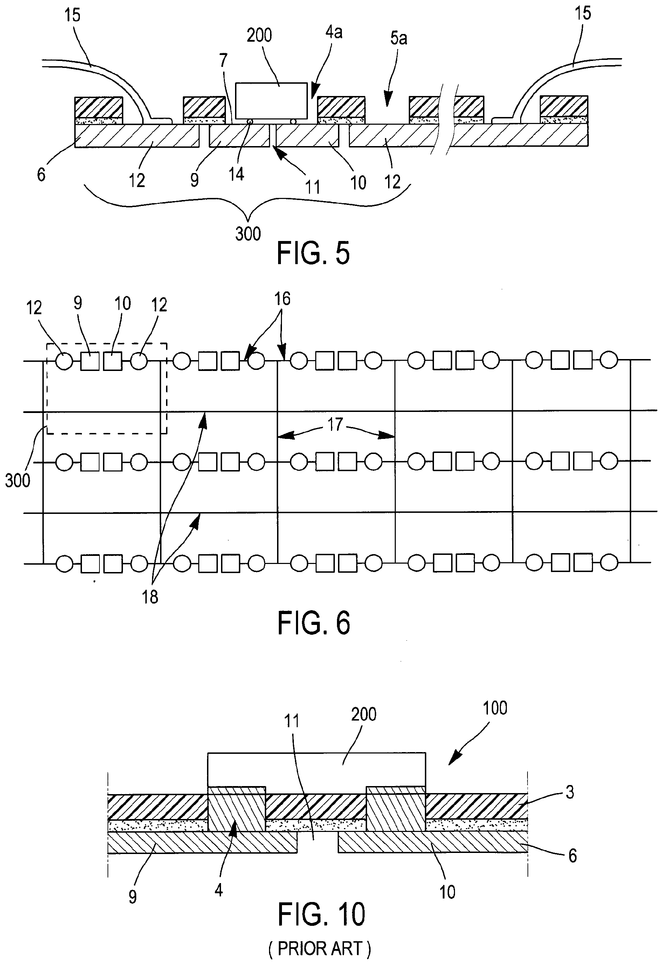

An example of prior art interconnection substrate is disclosed for instance in the patent application PCT/EP2012/067941 filed on October 13th 2011. The disclosure of this prior at document is explained in reference to figure 10. This document describes an interconnection substrate 100 for electronic components 200. This interconnection substrate 100 comprises an insulating layer 3 with a plurality of through holes 4 and an electrically conductive layer 6 laid over the insulating layer 3. The conductive layer 6 comprises a plurality of connecting units (only one connecting unit is shown on figure 10) arranged according to an array of rows and columns. Each connecting unit comprises two component pads 9, 10, each one of which at least partially covering a component through hole 4. A gap 11 between these two component pads electrically insulates the component pads 9, 10 from one another. Connecting units in a row are electrically connected with connection traces.

Other examples of substrates for interconnecting components are also disclosed in the patent application EP2447596A2 or WO9844768A1.

Prior art interconnection substrates have in particular the drawback that, when a pattern design is produced for electrically connecting several components together, there is no possibility for modifying the electrical function or electrical connection pattern (circuit) of the interconnection substrate.

A purpose of the present invention is to give an additional flexibility and adaptability so as to allow obtaining various connection patterns from a same interconnection substrate, for applications which require changes in the electrical interconnection circuit between components.

This purpose is in particular achieved with an interconnection substrate comprising a plurality of connecting units arranged in rows and columns. Connecting units comprise pads for electrically connecting components. According to the invention, connecting units in a row are electrically connected with first connection traces and connecting units in columns are electrically connected with second connection traces. Furthermore, second connection traces are electrically connected to one another by third connection traces extending substantially in the row direction between two rows of pads.

The pattern of the interconnection substrate according to the invention is designed so as to take into account an additional process step, that will be performed after component assembly, and which will finalize the electrical configuration of the circuitry.

The interconnection substrate is brought in this state to the component assembly line and receives components. At this stage, all components are short-circuited.

The conductive pattern on the interconnection substrate (PCB/FPC/FEC) has more interconnections than needed, additional conductive traces are provided for allowing subsequent disconnections at specific locations. Then, producing many versions of electrical interconnection between components is possible.

The invention also relates to a manufacturing method of manufacturing interconnection substrates. In such a method, once the components are mounted onto the interconnection substrate, a configuration/disconnection step occurs. Alternatively, the connecting units are disconnected before mounting the components. Depending on the required electrical function or electrical connection diagram, a disconnection pattern is defined and applied to the interconnection substrate of the invention.

For instance, disconnections can be processed in mechanically punching holes through the interconnection substrate, cutting the conductive patterns at specific points. The disconnection step can also be an additional etch-back process step.

The result is that the expected electrical interconnection between the components is created. When the original design of the interconnection substrate and its connection pattern is done, all these potential specific disconnecting points are defined, and a map of all potential disconnection punched holes is done. The various combinations give different electrical circuits. A programmable punching equipment can receive the required programme, for selectively disconnecting sets of connecting units, and for creating the required electrical interconnections between components.

The interconnection substrate and method according to the invention allow for instance to populate a PCB/FPC/FEC with large numbers of components (LEDs for instance), and decide after assembly how many components will be interconnected together, and with which electrical scheme (series, parallel, compound, etc.)

The method according to the invention can be implemented as a reel-to-reel process. This is a significant advantage in terms of productivity and mass production.

### Brief description of the drawings

Other characteristics and advantages of the invention will readily appear from the following description and of the appending drawings.

On the drawings :
- Figures 1 to 5 are lateral sectional schematic views of a portion of an interconnection substrate according to the invention, at several stages of the manufacturing method according to the invention;
- Figure 6 schematically represents a portion of an example of interconnection substrate according to the invention, seen from above the of the face on which are designed the conductive traces intended to connect components once mounted on the interconnection substrate;
- Figure 7 to 9 schematically represents, in a way equivalent to the one of Figure 6, other examples of a portion of interconnection substrate according to the invention with various disconnecting points defining various sets of connecting units; and
- Figure 10 shows schematically an interconnection substrate of the prior art.

On the different figures, the same references signs designate like or similar elements.

### Detailed description

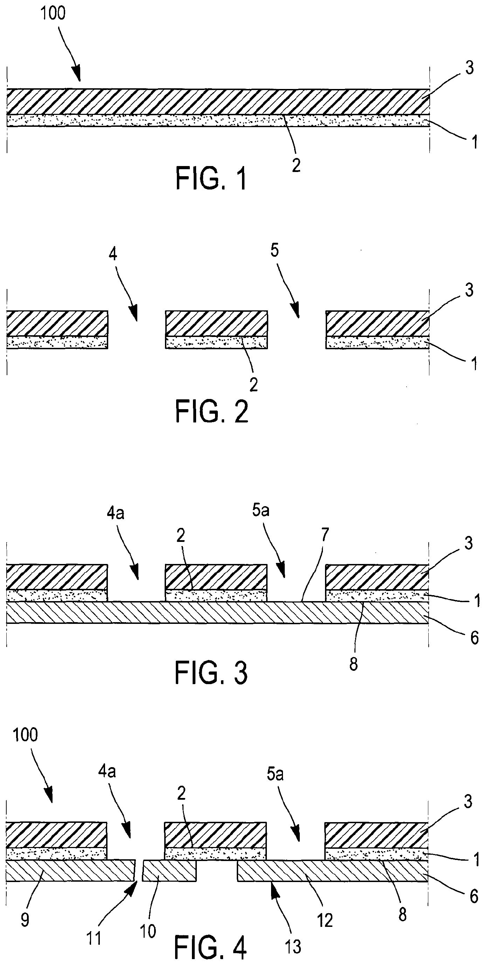

In reference to figures 2 to 5, a non-limitative example of the manufacturing method according to the invention is described. For the sake of simplification, figures 2 to 5 show only a short part of an interconnection substrate 100 according to the invention. But the manufacturing method according to the invention is performed on a greater surface of interconnection substrate 100, on which several electronic components 200 are mechanically mounted and electrically connected.

The electronic components 200 may be for example, transistors, resistors printed circuit boards or light emitting diodes. Preferentially they are bipolar components.

The method according to the invention begins with a step of spreading a glue layer 1 on a first principal face 2 of an insulating layer 3. The result of this step is schematically represented on figure 1.

Then, a punching step is performed in the insulating layer 3 to produce component through holes 4 and wiring through holes 5, as shown on figure 2. The component through holes 4 and wiring through holes 5 are drilled the same way. They essentially differ from each other by their respective dimensions that will allow for the component through holes 4 to receive electronic components and for the wiring through holes 5 to receive connection leads for feeding current to the electronic components as explained below.

At a bonding step, a conductive layer 6 is stacked and laminated on the glue layer 1. The result of this step is illustrated by figure 3. As a result, through holes 4, 5 are covered with the conductive layer 6. The through holes 4, 5 are now blind holes having bottom regions 7 made of conductive material as shown on figure 3. They now form cavities 4a, 5a. Prior to its bonding on the insulating layer 3, at least one face 8 of the conductive layer 6 might have been processed with suitable treatments. The bottom regions 7 of the conductive layer 6 may be deoxidized. In a variant, at least one face 8 of the conductive layer 6 may be deoxidized over the whole surface prior to its bonding on the insulating layer 3.

At the next step, the conductive layer 6 is patterned, for example by silk screen printing, photoengraving or PCB milling to create an interconnection pattern, i.e. to create conductor pathways or traces which will electrically connect the electronic components 200. The result of this step is schematically illustrated on figure 4. Each component cavity 4a is partially closed by 2 components pads 9, 10 electrically insulated from one another by a gap 11. Each wiring cavity 5a is closed by a wiring pad 12. Each component pad 9, 10 is electrically connected to a respective wiring pad 12. Adjacent wiring pads 12 are electrically connected to each other, as it will be further explained below. Furthermore and as it will be also explained below, the result of this patterning is a plurality of connecting units arranged according to an array of rows and columns.

Possibly, the conductive surface 13 of the conductive layer 6, opposite to the face 8 on which components 200 and connection leads will be attached, is protected. For example, a conformal coating is applied by dipping or spraying. This coating prevents corrosion and leakage currents or shorting due to condensation.

Possibly, an electroplating step is implemented, processed after the patterning step, for covering the connecting units with a conductive and protective layer, on the face on which components 200 and leads 15 will be connected. For this electroplating step, first, second and third conductive traces 16, 17, 18 are used for conducting the electroplating current. First, second and third conductive traces 16, 17, 18 are shown on figure 6.

At this stage, the interconnection substrate can be supplied to another manufacturer. This other manufacturer can be a packager which will fill in component cavities 4a with components 200 and will cut out sets made up of a plurality of components before packaging them for a subsequent mounting in devices by OEMs. For instance if components 200 are LEDs, OEMs may be lamp manufacturers. An advantage of the invention is that the interconnection substrate may also be used directly by lamp manufacturers. More particularly, when the electronic component 200 is an LED, it can be mounted directly on the interconnection substrate according to the invention, without prior packaging of the LED itself.

In any case, the next step may be a component mounting step. The result of this step is schematically illustrated on figure 5.

A solder paste 14 is deposited on the bottom regions 7 of the component cavities 4a and surface-mounted components 200 are placed in component cavities 4a, with a technique known by the person skilled in the art. This way, components 200 are electrically connected to component pads 9, 10. For instance, if components 200 are bipolar LEDs, its negative terminal is connected to a component pad which is then a cathode and its positive terminal is connected to a component pad which is then an anode. Alternatively, components 200 are connected to the component pads with a wire-bonding method.

Connecting leads 15 can be attached and electrically connected in wiring cavities 5a.

For the embodiment illustrated on figure 5, a connecting unit 300 comprises two component pads 9, 10 and two wiring pads 12. Such a connecting unit 300 is repeatedly reproduced several times in a row and may be also repeatedly reproduced several times in columns.

When a component 200 is picked and placed in each component cavity 4a of a set of connecting units arranged this way in row(s), and possibly in columns, a set of components is made in which the components 200 are connected, for instance in series, by means of the conductive layer 6 provided on the bottom face of the interconnection substrate 100.

A connecting lead 15 is attached at each end of such a set of connecting units. Since connecting units comprise two wiring pads, each one of which located next to and electrically connected to a respective component pad in the same row, it is always possible to cut out sets of connecting units so as to have wiring pads at both ends of the electrical path for connection to connecting leads 15. This allows providing pads 12 for connection to current feeding leads 15 at ends of rows and/or column independently of the number of connecting units that will be cut out for a further integration in a device.

When the components 200 are LEDs, the only leads 15 connected on the light emitting face are the leads connected at each end of the component series. The other electrical connexions to the LEDs are made by the conductive layer 6. As a consequence, the lighting is optimized.

The way sets of connecting units connected in series may be defined is illustrated on figures 6 to 9.

On figure 6 is shown a portion of interconnection substrate manufactured according to the method explained above. This portion of interconnection substrate comprises a lattice of connecting units 300 arranged in rows (from left to right for instance) and columns (from to top to bottom for instance). Each connecting unit 300 of this lattice comprises two component pads 9, 10 and two wiring pads 12. Each wiring pad 12 is electrically connected to a respective component pad 9 or 10. Two adjacent wiring pads 12 are electrically connected one with another. First connection traces 16 electrically connect a component pad 9 or 10 and a wiring pad 12 or two wiring pads 12 in a same row.

Connecting units in columns are electrically connected with second connection traces 17. These second connection traces 17 are electrically connected by third connection traces 18 extending substantially in the row direction between two rows of pads 9, 10, 12.

As far as flexibility and adaptability are concerned, it is advantageous that the second connection traces 17 electrically connect first connection traces 16 between two adjacent connecting units 300 in a row. Indeed, if we assume that the current flows from left to right on figure 6, this gives the possibility to disconnect two adjacent connecting units of a row after the node where the second connection trace 17 electrically connects the first connection traces 16, while keeping both the possibility to use the entire functionality of the next connecting unit and the possibility to use the third connection trace 18 for the return of the current at the beginning of the row just below.

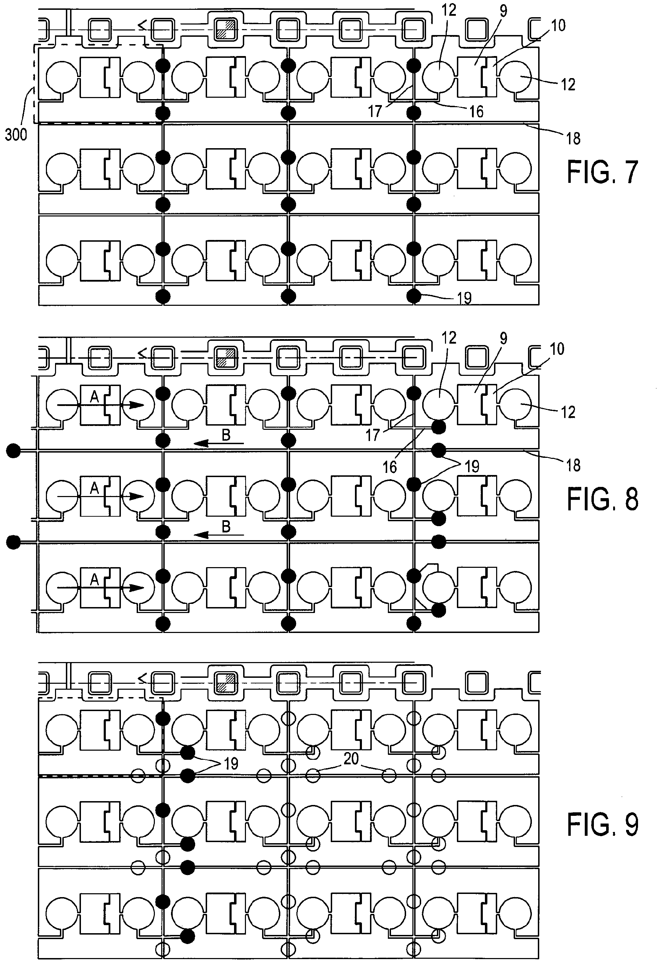

It can be considered that each connecting unit 300 is comprised of two component pads 9, 10, two wiring pads 12, a portion of first connection trace 16, a portion of second connection trace 17 and a portion of third connection trace 18. Each connecting unit 300 is designed so as to allow keeping its basic functionalities or properties (i.e. connecting to components 200, connecting to an adjacent connecting unit 300, connecting to connecting leads 15, and conducting the current in the third trace in a direction opposite to the direction in the first trace), even if disconnected from others. These basic properties will be better understood with figures 7 to 9.

Advantageously, first, second and third connection traces 16, 17, 18 have a thickness, a width and a conductivity adapted for conducting currents over lAmp, and more preferentially over 2Amps, without fusing. Such dimensions are also sufficient for carrying on the electroplating currents if electroplating steps are performed.

On figure 7 is schematically represented the face of interconnection substrate 100 opposite to the one supporting the components 200. It is an example of connecting unit lattice similar to the one of figure 6. Further, disconnecting points 19 are made on second connection traces 17. Such disconnecting points 19 may be made for instance by punching second connection traces 17 and the underlying interconnection substrate 100, or with an etch-back process.

Independent series of connecting units 300 are obtained this way, which can be further processed for instance for manufacturing LED lamps. As an example, on figure 7, tree series of four connecting units 300 are represented, which will then allow manufacturing three series of four LEDs .

On figure 8, similarly to figure 7, is schematically represented a portion of interconnection substrate seen from the face comprising the first, second and third connection traces 16, 17, 18 (i.e. the side opposite to the one supporting the components 200). Further, disconnecting points 19 are made at specific locations of the first, second and connection traces 16, 17, 18. This way a set of n times m (here with n=m=3) connecting units are obtained. The connecting units of this set are electrically connected in series. Indeed, if the current flows in the row of pads 9, 10, 12 from left to right (see the arrow A), it will also flow from left to right in first connection traces 16, from top to bottom in the second connection traces 17 and from right to left in the third connection traces 18 (see arrow B). In every row of pads 9, 10, 12 the current will flow in the same direction (from left to right). Such configuration allows picking and placing the components 200 always with the same orientation with the pick-and-place machine. This is a significant advantage from the processing stand point.

Figure 9 is similar to figures 7 and 8 and represents a portion of interconnection substrate with rows and columns of connecting units. Small white circles 20 represent various possible locations for disconnecting points 19. Small black circles represent disconnecting points 19 actually processed.

With an appropriate software, it is possible to control a programmable punching equipment, for selectively disconnecting sets of connecting units, and for creating the required electrical interconnection patterns between components. The software allows defining which ones of the small white circles 20 become disconnecting points 19.

In the case of LED chip assembly, the interconnection substrate according to the invention advantageously has an insulating layer which is substantially reflective and an electrically conductive layer having received an appropriate finishing, for instance electroplated sliver, for optimizing its light reflectivity on the bottom regions 7 of the chips receiving cavities 4a and wiring cavities 5b.

## Claims

1. An interconnection substrate (100) for electronic components (200) comprising
- an insulating layer (3) with a plurality of through holes (4, 5),
- an electrically conductive layer (6) laid over the insulating layer (3),
wherein the conductive layer (6) comprises a plurality of connecting units (300) arranged according to an array of rows and columns,
wherein each connecting unit (300) of this plurality of connecting units comprises two component pads (9, 10), each one of which at least partially covering a component through hole (4), with a gap (11) between these two component pads (9, 10) so as to electrically insulate them from one another, and
**characterized**
**in that** connecting units (300) in a row direction are electrically connected with first connection traces (16), said two component pads (9,10) being connected in a row by first connection traces (16),
**in that** connecting units (300) in columns are electrically connected with second connection traces (17), and
**in that** second connection traces (17) are electrically connected to one another by third connection traces (18) extending in the row direction and between two rows of said component pads (9, 10).

2. An interconnection substrate according to claim 1, wherein second connection traces (17) electrically connect first connection traces (16) between two adjacent connecting units (300) in a row.

3. An interconnection substrate according to claim 1 or 2, wherein connecting units (300) comprise two wiring pads (12) each one located next to and electrically connected to a respective component pad (9, 10) in the same row.

4. An interconnection substrate according to claim 3, wherein wiring pads (12) cover wiring through holes (5).

5. An interconnection substrate according to any preceding claims, wherein first, second and third connection traces (16, 17, 18) have a thickness, a width and a conductivity adapted for conducting currents over lAmp, and more preferentially over 2Amps, without fusing.

6. An interconnection substrate according to any preceding claims, wherein first, second and third conductive traces (16, 17, 18) are electrically disconnected at selected locations (19) so to make sets of a defined number of connecting units (300) electrically connected in series and arranged in n row and m columns.

7. Method for manufacturing an interconnection substrate according to any one of the preceding claims, comprising the following steps
- providing an insulating layer (3),
- spreading a glue layer (1) over the insulating layer (3),
- punching through holes (4, 5) in the insulating layer (3),
- laminating an electrically conductive layer (6) laid over the glue layer (1),
- patterning the conductive layer (6) so to form a plurality of connecting units (300) arranged according to an array of rows and columns,
wherein each connecting unit (300) of this plurality of connecting units comprises two component pads (9, 10), each one of which at least partially covering a component through hole (4), with a gap (11) between these two component pads (9, 10) so as to electrically insulate them from one another, and
**characterized**
**in that** connecting units (300) in a row direction are electrically connected with first connection traces (16), said two component pads (9,10) being connected in a row by first connection traces (16),
**in that** connecting units (300) in columns are electrically connected with second connection traces (17), and
**in that** second connection traces are electrically connected by third connection traces (18) extending in the row direction and between two rows of said component pads (9, 10).

8. Method according to claim 7, comprising an electroplating step, processed after the patterning step, for covering the connecting units (300) with a conductive and protective layer, first, second and third conductive traces (16, 17, 18) being used for conducting current during this electroplating step.

9. Method according to claim 7 or 8, comprising a disconnecting step the first, second and third conductive traces at selected locations (19) so to make sets of a defined number of connecting units (300) electrically connected in series and arranged in n row and m columns.

10. Method according to claim 9, wherein the disconnecting step is processed with a tool controlled by a software programmed for varying the numbers n and m, respectively of rows and columns, so as to manufacture sets with various numbers of connecting units, from the same interconnection substrates, without changing the disconnecting tool.

## Patentansprüche

1. Verbindungssubstrat (100) für elektronische Komponenten (200), umfassend:
- eine Isolierschicht (3) mit einer Vielzahl von Durchgangslöchern (4, 5),
- eine elektrisch leitende Schicht (6), die über die Isolierschicht (3) gelegt ist,
wobei die leitende Schicht (6) eine Vielzahl von Verbindungseinheiten (300) umfasst, die entsprechend einer Anordnung von Reihen und Spalten angeordnet sind,
wobei jede Verbindungseinheit (300) dieser Vielzahl von Verbindungseinheiten zwei Komponentenkontaktstellen (9, 10) umfasst, von denen jede ein Komponentendurchgangsloch (4) zumindest teilweise bedeckt, mit einem Spalt (11) zwischen diesen zwei Komponentenkontaktstellen (9, 10), um sie elektrisch voneinander zu isolieren, und
**dadurch gekennzeichnet,**
**dass** Verbindungseinheiten (300) in einer Reihenrichtung mit ersten Verbindungsbahnen (16) elektrisch verbunden sind, wobei die zwei Komponentenkontaktstellen (9, 10) durch erste Verbindungsbahnen (16) in einer Reihe verbunden sind,
**dass** Verbindungseinheiten (300) in Spalten elektrisch mit zweiten Verbindungsbahnen (17) verbunden sind, und
**dass** zweite Verbindungsbahnen (17) elektrisch miteinander verbunden sind durch dritte Verbindungsbahnen (18), die sich in der Reihenrichtung und zwischen zwei Reihen der Komponentenkontaktstellen (9, 10) erstrecken.

2. Verbindungssubstrat nach Anspruch 1, wobei zweite Verbindungsbahnen (17) erste Verbindungsbahnen (16) zwischen zwei benachbarten Verbindungseinheiten (300) in einer Reihe elektrisch verbinden.

3. Verbindungssubstrat nach Anspruch 1 oder 2, wobei Verbindungseinheiten (300) zwei Verdrahtungskontaktstellen (12) aufweisen, die jeweils neben einer jeweiligen Komponentenkontaktstelle (9, 10) in der gleichen Reihe angeordnet und elektrisch mit dieser verbunden sind.

4. Verbindungssubstrat nach Anspruch 3, wobei Verdrahtungskontaktstellen (12) Verdrahtungsdurchgangslöcher (5) bedecken.

5. Verbindungssubstrat nach einem der vorhergehenden Ansprüche, wobei erste, zweite und dritte Verbindungsbahnen (16, 17, 18) eine Dicke, eine Breite und eine Leitfähigkeit aufweisen, die zum Leiten von Strömen über 1 Amp, und bevorzugter über 2 Amp, ohne Schmelzen eingerichtet sind.

6. Verbindungssubstrat nach einem der vorhergehenden Ansprüche, wobei erste, zweite und dritte Leiterbahnen (16, 17, 18) an ausgewählten Stellen (19) elektrisch getrennt sind, um auf diese Weise Sätze einer definierten Anzahl von Verbindungseinheiten (300) zu bilden, die elektrisch in Serie geschaltet und in n Reihen und m Spalten angeordnet sind.

7. Verfahren zur Herstellung eines Verbindungssubstrats nach einem der vorhergehenden Ansprüche, umfassend die folgenden Schritte:
- Bereitstellen einer Isolierschicht (3),
- Auftragen einer Klebstoffschicht (1) auf der Isolierschicht (3),
- Stanzen von Durchgangslöchern (4, 5) in die Isolierschicht (3),
- Laminieren einer elektrisch leitenden Schicht (6), die über die Klebstoffschicht (1) gelegt wird,
- Strukturieren der leitenden Schicht (6) derart, dass eine Vielzahl von Verbindungseinheiten (300) gebildet wird, die entsprechend einer Anordnung von Reihen und Spalten angeordnet sind,
wobei jede Verbindungseinheit (300) dieser Vielzahl von Verbindungseinheiten zwei Komponentenkontaktstellen (9, 10) umfasst, von denen jede ein Komponentendurchgangsloch (4) zumindest teilweise bedeckt, mit einem Spalt (11) zwischen diesen zwei Komponentenkontaktstellen (9, 10), um sie elektrisch voneinander zu isolieren, und
**dadurch gekennzeichnet,**
**dass** Verbindungseinheiten (300) in einer Reihenrichtung mit ersten Verbindungsbahnen (16) elektrisch verbunden sind, wobei die zwei Komponentenkontaktstellen (9, 10) durch erste Verbindungsbahnen (16) in einer Reihe verbunden sind,
**dass** Verbindungseinheiten (300) in Spalten elektrisch mit zweiten Verbindungsbahnen (17) verbunden sind, und
**dass** zweite Verbindungsbahnen elektrisch verbunden sind durch dritte Verbindungsbahnen (18), die sich in der Reihenrichtung und zwischen zwei Reihen der Komponentenkontaktstellen (9, 10) erstrecken.

8. Verfahren nach Anspruch 7, umfassend einen Galvanisierungsschritt, durchgeführt nach dem Strukturierungsschritt, zum Bedecken der Verbindungseinheiten (300) mit einer Leitungs- und Schutzschicht, wobei erste, zweite und dritte Leiterbahnen (16, 17, 18) zum Leiten von Strom während dieses Galvanisierungsschritts verwendet werden.

9. Verfahren nach Anspruch 7 oder 8, umfassend einen Trennungsschritt der ersten, zweiten und dritten Leiterbahnen an ausgewählten Stellen (19), um auf diese Weise Sätze einer definierten Anzahl von Verbindungseinheiten (300) herzustellen, die elektrisch in Serie geschaltet und in n Reihen und m Spalten angeordnet sind.

10. Verfahren nach Anspruch 9, wobei der Trennungsschritt mit einem Werkzeug durchgeführt wird, das von einer Software gesteuert wird, die zum Variieren der Anzahlen n und m der Reihen bzw. Spalten programmiert ist, um Sätze mit unterschiedlichen Anzahlen von Verbindungseinheiten aus den gleichen Verbindungssubstraten herzustellen, ohne das Trennwerkzeug zu wechseln.

## Revendications

1. Substrat d'interconnexion (100) pour composants électroniques (200) comprenant
- une couche isolante (3) avec une pluralité de trous traversants (4, 5),
- une couche électriquement conductrice (6) reposant sur la couche isolante (3), la couche conductrice (6) comprenant une pluralité d'unités de connexion (300) agencées selon un réseau de rangées et de colonnes,
chaque unité de connexion (300) de cette pluralité d'unités de connexion comprenant deux plots de composant (9, 10), dont chacun recouvre au moins partiellement un trou traversant de composant (4), avec un espace (11) entre ces deux plots de composant (9, 10) de manière à les isoler électriquement l'un de l'autre, et
**caractérisé**
**en ce que** des unités de connexion (300) dans une direction de rangée sont connectées électriquement à des premières pistes de connexion (16), lesdits deux plots de composant (9, 10) étant connectés en rangée par des premières pistes de connexion (16),
**en ce que** les unités de connexion (300) en colonnes sont connectées électriquement à des deuxièmes pistes de connexion (17), et
**en ce que** les deuxièmes pistes de connexion (17) sont connectées électriquement entre elles par des troisièmes pistes de connexion (18) s'étendant dans la direction des rangées et entre deux rangées desdits plots de composant (9, 10).

2. Substrat d'interconnexion selon la revendication 1, dans lequel des deuxièmes pistes de connexion (17) connectent électriquement des premières pistes de connexion (16) entre deux unités de connexion adjacentes (300) dans une rangée.

3. Substrat d'interconnexion selon la revendication 1 ou 2, dans lequel des unités de connexion (300) comprennent deux plots de câblage (12), chacun étant situé à côté et connecté électriquement à un plot de composant respectif (9,10) dans la même rangée.

4. Substrat d'interconnexion selon la revendication 3, dans lequel les plots de câblage (12) recouvrent des trous traversants de câblage (5).

5. Substrat d'interconnexion selon l'une quelconque des revendications précédentes, dans lequel les première, deuxième et troisième pistes de connexion (16, 17, 18) ont une épaisseur, une largeur et une conductivité adaptées pour conduire des courants de plus de 1 ampère et de préférence de plus de 2 ampères, sans fusion.

6. Substrat d'interconnexion selon l'une quelconque des revendications précédentes, dans lequel les première, deuxième et troisième pistes conductrices (16, 17, 18) sont déconnectées électriquement au niveau d'emplacements sélectionnés (19) de manière à constituer des ensembles d'un nombre défini d'unités de connexion (300) connectées électriquement en série et agencées en n rangées et m colonnes.

7. Procédé de fabrication d'un substrat d'interconnexion selon l'une quelconque des revendications précédentes, comprenant les étapes suivantes :
- la fourniture d'une couche isolante (3),
- l'étalement d'une couche de colle (1) sur la couche isolante (3),
- la perforation de trous traversants (4, 5) dans la couche isolante (3),
- la lamination d'une couche conductrice d'électricité (6) posée sur la couche de colle (1),
- la structuration de la couche conductrice (6) de manière à former une pluralité d'unités de connexion (300) agencées selon un réseau de rangées et de colonnes,
chaque unité de connexion (300) de cette pluralité d'unités de connexion comprenant deux plots de composant (9, 10), dont chacun recouvre au moins partiellement un trou traversant de composant (4), avec un espace (11) entre ces deux plots de composant (9, 10) de manière à les isoler électriquement l'un de l'autre, et
**caractérisé**
**en ce que** des unités de connexion (300) dans une direction de rangée sont connectées électriquement à des premières pistes de connexion (16), lesdits deux plots de composant (9, 10) étant connectés en rangée par des premières pistes de connexion (16),
**en ce que** les unités de connexion (300) en colonnes sont connectées électriquement à des deuxièmes pistes de connexion (17), et
**en ce que** les deuxièmes pistes de connexion sont connectées électriquement par des troisièmes pistes de connexion (18) s'étendant dans la direction de rangée et entre deux rangées desdits plots de composant (9, 10).

8. Procédé selon la revendication 7, comprenant une étape d'électrodéposition, traitée après l'étape de structuration, pour recouvrir les unités de connexion (300) d'une couche conductrice et protectrice, des première, deuxième et troisième pistes conductrices (16, 17, 18) étant utilisées pour conduire le courant pendant cette étape d'électrodéposition.

9. Procédé selon la revendication 7 ou 8, comprenant une étape de déconnexion des première, deuxième et troisième pistes conductrices au niveau d'emplacements sélectionnés (19) de manière à réaliser des ensembles d'un nombre défini d'unités de connexion (300) connectées électriquement en série et agencées en n rangées et m colonnes.

10. Procédé selon la revendication 9, dans lequel l'étape de déconnexion est traitée avec un outil commandé par un logiciel programmé pour faire varier les nombres n et m, respectivement de rangées et de colonnes, de manière à fabriquer des ensembles avec différents nombres d'unités de connexion, à partir des mêmes substrats d'interconnexion, sans changer l'outil de déconnexion.
